# EUROPÄISCHE PATENTSCHRIFT

(11) **EP 0 745 274 B1**
(45) Veröffentlichungstag und Bekanntmachung des Hinweises auf die Patenterteilung: **30.08.2000**
(21) Anmeldenummer: 95907552.4
(22) Anmeldetag: 02.02.1995
(51) Int. Cl.: H01L 25/065, H01L 21/60

(54) **VERFAHREN ZUR HERSTELLUNG EINER DREIDIMENSIONALEN SCHALTUNGSANORDNUNG**
PROCESS FOR PRODUCING A THREE-DIMENSIONAL CIRCUIT
PROCEDE DE REALISATION D'UN CIRCUIT TRIDIMENSIONNEL

(30) Priorität: 16.02.1994 DE 4404905; 03.08.1994 DE 4427516
(43) Veröffentlichungstag der Anmeldung: 04.12.1996
(73) Patentinhaber: SIEMENS AKTIENGESELLSCHAFT, 80333 München (DE)
(72) Erfinder: HÜBNER, Holger, D-85598 Baldham (DE)
(86) Internationale Anmeldenummer: DE9500137
(87) Internationale Veröffentlichungsnummer: WO9522840

(56) Entgegenhaltungen:
- DE-A- 4 241 439
- MICROELECTRONIC ENGINEERING, Bd. 15,Nr. 1/4, Oktober 1991 AMSTERDAM NL, Seiten 167-174, MORIYA ET AL 'Resultsof the three-dimensional integrated circuits project in Japan'
- IEEE MICRO, Bd. 13,Nr. 2, April 1993 LOS ALAMOS,CA,USA, Seiten 46-58, MACKAY 'Amalgams for improved electronics interconnection'

## Beschreibung

Es werden zunehmend Halbleiterschaltungen entworfen, in denen integrierte Schaltungen in mehreren Ebenen übereinander gestapelt und miteinander verbunden werden. Insbesondere werden dabei integrierte Schaltungen verschiedener Technologien kombiniert.

Zur Erhöhung der Packungsdichte und Verkürzung der Verbindungswege werden derartige Stapel von verschiedenen integrierten Schaltungen in einem Chipgehäuse zusammengefaßt. Dabei werden die die integrierten Schaltungen enthaltenden Substrate, die aus unterschiedlichen Substratmaterialien bestehen können und/oder in unterschiedlichen Technologien gefertigt sein können, jeweils bis auf wenige 10 µm dünn geschliffen und als Stapel, auch Stack genannt, angeordnet. In senkrechter Richtung werden durch die Substrate hindurch Kontakte gebildet. Ein solcher Bauelementstapel erscheint von außen betrachtet als neuer Halbleiterbaustein. Er kann in einem Standardgehäuse mit reduzierter Anschlußzahl realisiert werden, obgleich er eine gesteigerte Funktionalität aufweist.

Aus Y. Hayashi et al, Symp. on VLSI Techn. (1990) Seite 95 bis 96 ist bekannt, zur mechanischen Verbindung zwischen benachbarten Substraten eine Polyimidschicht als Klebeschicht zu verwenden. Die vertikalen Kontakte zwischen benachbarten Substraten werden über Wolframstifte und zugehörige großflächige Vertiefungen, die mit einer Au/In-Legierung gefüllt werden, realisiert. In diese gefüllten Vertiefungen tauchen die Wolframstifte beim Übereinanderstapeln des oberen Substrates und des unteren Substrates ein. Sie werden bei 300 bis 400°C verlötet. Dabei kommt es zu einer unterschiedlichen thermischen Ausdehnung der beiden Ebenen, die zu einer lateralen Verschiebung der Metallkontakte fuhrt, die dabei abgeschert werden können.

Bedingt durch die höhere Packungsdichte in dreidimensional integrierten Schaltungsanordnungen steigt in einem solchen Bauelementestapel die abzuführende Verlustwärme. Die Polyimidschicht trägt zur Abführung der Verlustwärme kaum bei, so daß diese über die Wolframstifte und die Substrate selbst abgeführt werden muß.

In der Offenlegungsschrift DE 42 41 439 A1 wird ein Verfahren zur Erzeugung einer formschlüssigen Verbindung zwischen metallischen Verbindern und metallischen Kontakten von Halbleiteroberflächen beschrieben. Dazu wird zwischen dem Verbinder und dem Kontakt niedrigschmelzendes Metall angeordnet und erhitzt, so, daß sich eine intermetallische Phase bildet, deren Schmelztemperatur höher ist als die des niedrigschmelzenden Metalls. Die intermetallische Phase härtet aus und verbindet dadurch den Verbinder und den Kontakt miteinander.

In IEEE Micro Band 13, Nr. 2, April 1993 wird Amalgam als Alternative zum Lotmetall in der Mikroelektronik vorgeschlagen. Das Amalgam wird durch Mischung eines flüssigen Metalls mit einem Pulver erzeugt. Das flüssige Metall kann eine niedrigere Schmelztemperatur als die des Amalgams aufweisen. Die Vorteile der Verwendung von Amalgam im Gegensatz zu Lotmetall zur Herstellung von Verbindungen, bestehen darin, daß zum einen besonders stabile Verbindungen aufgrund der hohen Schmelztemperatur des Amalgams entstehen, und zu anderen die Betriebstemperatur bei der Herstellung des Verfahrens aufgrund der niedrigen Schmelztemperatur des flüssigen Metalls besonders niedrig ist.

Der Erfindung liegt das Problem zugrunde, ein Verfahren zur Herstellung einer dreidimensionalen Schaltungsanordnung anzugeben, mit dem eine dreidimensionale Schaltungsanordnung herstellbar ist, in der mechanische Spannungen, die durch unterschiedliche thermische Ausdehnungen bei der Verbindung der Substrate entstehen, reduziert werden.

Dieses Problem wird erfindungsgemäß gelöst durch ein Verfahren nach Anspruch 1. Weitere Ausgestaltungen der Erfindung gehen aus den übrigen Ansprüchen hervor.

Der Begriff "Substrat" wird hier sowohl für Substratscheiben, die insbesondere aus Halbleitermaterial bestehen und mikroelektronische Schaltungsstrukturen und/oder optoelektronische Komponenten und/oder Sensorkomponenten umfassen, als auch für vereinzelte Bauelemente, optoelektronische Komponenten, Sensorelemente oder ähnliches verwendet.

Der Begriff "Bauelement" wird sowohl für mikroelektronische Schaltungsstrukturen als auch für optoelektronische Komponenten, Sensorkomponenten oder ähnliches verwendet.

Zum Aufbau einer dreidimensionalen Schaltungsanordnung ist es zweckmäßig, auf einer Substratscheibe, die eine Vielzahl von Bauelementen umfaßt, vereinzelte Bauelemente als zweites Substrat jeweils oberhalb eines getesteten und für gut befundenen Bauelementes der Substratscheibe zu positionieren. Nach der elektrischen und mechanischen Verbindung zwischen beiden Substraten ist es wiederum zweckmäßig, die Schaltungsanordnung zu testen, da bei den verschiedenen Bearbeitungsschritten die Bauelemente beschädigt werden können. Durch Tests jeweils nach Aufbringen eines weiteren Substrates wird die effektive Ausbeute bei der Herstellung dreidimensional integrierter Schaltungsanordnungen vergrößert.

In dem erfindungsgemäßen Verfahren wird die mechanische Verbindung zwischen benachbarten Substraten über Metallflächen realisiert, die auf mindestens einer angrenzenden Hauptfläche eines der Substrate angeordnet sind und die durch Aufbringen von Lotmetall und Erhitzen mit der angrenzenden Hauptfläche des anderen Substrats verlötet werden. Da die mechanische Verbindung über Metallflächen erfolgt, ist in einer nach dem erfindungsgemäßen Verfahren hergestellten dreidimensionalen Schaltungsanordnung ein gegenüber dem Stand der Technik verbesserter Abtransport der Verlustwärme sichergestellt.

Die Metallflächen werden aus einem Material gebildet, das sich mit dem Lotmetall zu einer intermetallischen Phase durchmischt, deren Schmelztemperatur höher als die Betriebstemperatur der dreidimensionalen Schaltungsanordnung ist. Das Lotmetall vermischt sich vollständig mit dem Material der Metallflächen, so daß nach dem Verlöten zwischen den Substraten kein reines Lotmetall verbleibt. Es können der dreidimensionalen Schaltungsanordnung nach demselben Verfahren weitere Ebenen hinzugefügt werden, ohne daß ein Aufschmelzen bereits fertiger Lötverbindungen zu befürchten ist. Vorzugsweise werden die Metallflächen aus Nickel gebildet. Als Lotmetall wird dann Gallium verwendet.

Die Menge des Lotmetalls wird dabei so bemessen, daß sich bei der Durchmischung mit dem Material der zusätzlichen Metallflächen eine intermetallische Phase mit einem Galliumanteil von maximal 25 Gewichtsprozent bildet. Eine solche intermetallische Phase weist eine Schmelztemperatur von über 1200°C auf.

Beim Verlöten der beiden Substrate muß darauf geachtet werden, daß das Reagieren von Lotmetall und Material der Metallflächen erst beginnt, wenn beide Substrate über das flüssige Lotmetall in Kontakt stehen. Dieses kann dadurch gewährleistet werden, daß die Substrate erst erhitzt werden, wenn die Metallflächen mit dem festen Lotmetall in Berührung stehen.

Alternativ wird die Oberfläche derjenigen Metallflächen, vor dem Aufbringen des Lotmetalls mit einer Diffusionsbarriereschicht aus zum Beispiel Ti oder TiN versehen, die die Diffusion des Lotmetalls in das Material der Metallfläche verzögert. In diesem Fall kann das Lotmetall erhitzt und verflüssigt werden und dann mit den Metallflächen in Verbindung gebracht werden.

Es liegt im Rahmen der Erfindung, zusätzliche Metallflächen, die jeweils an eine der erstgenannten Metallflächen angrenzen, auf der Hauptfläche des jeweils anderen Substrates aufzubringen und die erstgenannte Metallfläche mit den angrenzenden zusätzlichen Metallflächen zu verlöten. Dadurch werden unter anderem Benetzungsprobleme des Lotmetalls mit der Hauptfläche des anderen Substrats vermieden.

Die zusätzlichen Metallflächen werden in dem erfindungsgemäßen Verfahren vorzugsweise aus einem Metall gebildet, das sich beim Verlöten mit dem Lotmetall nur geringfügig vermischt. Dadurch verändert sich die zusätzliche Metallfläche beim Löten kaum. Vorzugsweise werden die zusätzlichen Metallflächen aus Wolfram gebildet, das nur eine geringe Löslichkeit mit anderen Metallen aufweist.

Wird beim Testen von nach dem erfindungsgemäßen Verfahren zusammengefügten Substraten ein fehlerhaftes Bauelement erkannt, so liegt es im Rahmen der Erfindung, das gesamte Substrat mit dem fehlerhaften Bauelement mechanisch abzuschleifen. Dazu werden vorzugsweise Schleifverfahren verwendet, die zum Schleifen von optischen Linsen und Prismen bekannt sind. Dabei wird insbesondere eine plane Schleifscheibe mit flüssiger Diamantschleifpaste mit Korngrößen von zum Beispiel 1/4 µm eingesetzt. Beim Abschleifen wird auch das Lotmetall entfernt. Die zusätzlichen Metallflächen werden angeschliffen. Danach weist die Oberfläche des Substrats mit den zusätzlichen Metallflächen genau die Gestalt auf, die sie vor dem Aufbringen des Lotmetalls und des zweiten Substrats hatte. Abgesehen von einem Reinigungsschritt sind daher keine weiteren Prozeßschritte zur Restaurierung der Oberfläche des Substrats mit den zusätzlichen Metallflächen notwendig, bevor wiederum ein weiteres Substrat darauf gestapelt und damit mechanisch verbunden wird.

Mit dem erfindungsgemäßen Verfahren können beliebig viele Substrate übereinander angeordnet und miteinander verbunden werden. Es ist dabei vorteilhaft, jeweils nach dem Aufbringen eines weiteren Substrats die Funktionsfähigkeit der dreidimensionalen Schaltungsanordnung zu testen und, falls erforderlich, das zuletzt hinzugefügte Substrat durch Abschleifen zu entfernen.

Im Hinblick auf ein eventuelles späteres Abschleifen fehlerhafter Substrate ist es vorteilhaft, eine Diffusionsbarriereschicht auf den Metallflächen auf demjenigen Substrat vorzusehen, das nach dem Abschleifen des fehlerhaften Substrates, das in der Regel das hinzugefügte ist, für den weiteren Aufbau der dreidimensionalen Schaltungsanordnung weiter verwendet wird. Die Diffusionsbarriereschicht stellt in diesem Fall sicher, daß die Metallflächen beim Löten im wesentlichen unverändert bleiben.

Es liegt im Rahmen der Erfindung, Kontakte, die in beiden Substraten an die an das andere Substrat angrenzende Hauptfläche angrenzen, beim Verlöten elektrisch miteinander zu verbinden. Bei aufeinandertreffenden Kontakten in den beiden Substraten erfolgt dieses über direktes Verlöten. Bei versetzt angeordneten Substraten liegt es im Rahmen der Erfindung, mindestens eine Metallfläche so auszubilden, daß sie eine Leiterbahn zwischen den beiden Kontakten parallel zur Hauptfläche der Substrate bildet. Da zu verbindende Kontakte plan aufeinandertreffen und sich nicht verzahnen, wie dies im Stand der Technik der Fall ist, führen unterschiedliche thermische Ausdehnungen nur zu einer lateralen Verschiebung. Mechanische Belastungen der Kontakte werden dabei vermieden.

Die an die Hauptfläche angrenzenden Kontakte müssen sich mit demselben Lotmetall wie die Metallflächen löten lassen. Dabei können die Kontakte aus demselben Metall wie die Metallflächen gebildet sein, was zu einer Prozeßvereinfachung führt. Es ist ebenso möglich, die Kontakte aus anderen Metallen als die Metallflächen zu bilden. In diesem Fall können die elektrischen Eigenschaften der Kontakte unabhängig von den mechanischen Eigenschaften der Metallflächen optimiert werden. Als Metall für die Kontakte ist unter anderem Kupfer, Silber oder Wolfram geeignet.

Um ungewollte elektrische Verbindungen zwischen Metallflächen und benachbarten Kontakten zu vermeiden, liegt es im Rahmen der Erfindung, zwischen benachbarten Metallflächen und Kontakten isolierende Graben auszubilden.

Die den Metallflächen benachbarten isolierenden Gräben ermöglichen darüber hinaus beim Zusammenfügen von benachbarten Substraten das Entweichen von eingeschlossener Luft oder Gas. Insbesondere beim Fügen großflächiger Substrate besteht die Gefahr, daß es zu einer Verbindung geschlossener Randbereiche kommt, bevor die Luft- oder Schutzgasatmosphäre zwischen den benachbarten Substraten vollständig entweichen konnte. In diesem Fall bildet sich ein eingeschlossenes Luftkissen, das die vollständige Verbindung der Substrate verhindern würde. Diese Luft oder dieses Gas kann jedoch über die isolierenden Gräben entweichen.

Um sicherzustellen, daß ein Kurzschluß zwischen den Metallflächen und benachbarten Kontakten vermieden wird, ist der Boden der isolierenden Gräben mindestens am Rand mit einer Hilfsschicht bedeckt, die vom Lotmetall nicht benetzbar ist. Die Hilfsschicht ist insbesondere als Flankenbedeckung entlang den angrenzenden Flanken der Metallflächen ausgebildet. Alternativ wird die Hilfsschicht unter der Metallfläche angeordnet.

Die Hilfsschicht wird vorzugsweise aus Wolfram, Tantal, Aluminium oder einem Polymer gebildet.

Besteht die Hilfsschicht aus einem Material mit ausreichender elektrischer Leitfähigkeit, das heißt einem Metall, so muß die Hilfsschicht zwischen einer Metallfläche und einem benachbarten Kontakt im Bereich des isolierenden Grabens unterbrochen sein, um Kurzschlüsse zwischen der Metallfläche und dem Kontakt zu vermeiden.

Da die Hilfsschicht aus nicht benetzbarem Material am Rand der Metallflächen und Kontakte angeordnet ist, reißt das Lotmetall am Rand der Metallflächen und Kontakte ab. Während des Lötvorgangs bilden sich dann an den Rändern der Metallflächen Menisken aus. Die Oberflächenspannung des flüssigen Lotmetalls verhindert, daß dieses mit dem flüssigen Lotmetall am benachbarten Kontakt einen Kurzschluß bildet.

Alternativ werden diese isolierenden Gräben mit Material gefüllt, das vom Lotmetall nicht benetzt wird. Dazu ist zum Beispiel Silikon oder Polyimid geeignet. Während des Lötvorgangs bilden sich an den Rändern der Metallflächen Menisken aus. Die Oberflächenspannung des flüssigen Lotmetalls verhindert, daß dieses mit dem flüssigen Lotmetall am benachbarten Kontakt einen Kurzschluß bildet.

Im folgenden wird die Erfindung anhand der Figuren und der Ausführungsbeispiele naher erläutert.
- Figur 1: zeigt zwei Substrate, die über verlötete Metallflächen miteinander verbunden sind.
- Figur 2: zeigt zwei Substrate, die über verlötete Metallflächen miteinander verbunden sind und in denen eine Metallfläche eine Leiterbahn zwischen versetzt aufeinandertreffende Kontakten in beiden Substraten bildet.
- Figur 3: zeigt zwei Substrate, die über verlötete Metallflächen miteinander verbunden sind.

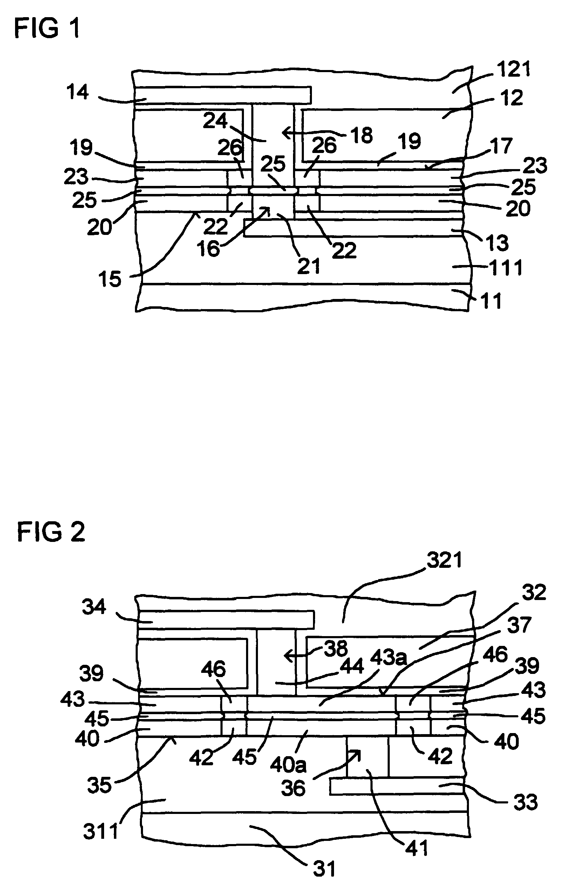

Ein erstes Substrat 11 (siehe Figur 1), das zum Beispiel eine Halbleiterscheibe aus einkristallinem Silizium oder ein III-V-Halbleiter ist, umfaßt Schaltungsstrukturen, die Bestandteil einer mikroelektronischen Schaltung oder einer optoelektronischen Komponente oder einer Sensorkomponente sind. Die Schaltungsstrukturen, die im einzelnen in Figur 1 nicht dargestellt sind, umfassen mindestens eine Metallisierungsebene 13, die durch eine SiO₂-Schicht 111 gegenüber dem Substrat 11 isoliert ist. Ein zweites Substrat 12 ist zum Beispiel ein vereinzelter Chip, der eine mikroelektronische Schaltung, eine optoelektronische Komponente oder eine Sensorkomponente umfaßt. Die Schaltungsstrukturen des zweiten Substrats 12 sind in Figur 1 nicht im einzelnen dargestellt. Sie umfassen mindestens eine Metallisierungsebene 14, die durch eine SiO₂-Schicht 121 gegenüber dem Substrat 12 isoliert ist. In einer ersten Hauptfläche 15 des ersten Substrates 11 wird ein erstes Kontaktloch 16 geöffnet. Das erste Kontaktloch 16 reicht bis auf die Metallisierungsebene 13.

In einer zweiten Hauptfläche 17 des zweiten Substrats 12 wird ein zweites Kontaktloch 18 geöffnet. Das zweite Kontaktloch 18 reicht auf die Metallisierungsebene 14. Die Oberfläche des zweiten Substrats 12 wird mit einer isolierenden Schicht 19 aus zum Beispiel SiO₂ versehen. Dabei bleibt im Bereich des zweiten Kontaktloches 18 die Oberfläche der Metallisierungsebene 14 unbedeckt.

Durch ganzflächige Abscheidung zum Beispiel in einem CVD-Verfahren und anschließende Strukturierung mit Hilfe eines photolithographischen Verfahrens einer Wolframschicht werden auf der ersten Hauptfläche 15 erste Metallflächen 20 und ein erster Kontakt 21 gebildet. Der erste Kontakt 21 füllt das erste Kontaktloch 16 aus.

Zwischen den ersten Metallflächen 20 und dem ersten Kontakt 21 entstehen isolierende Graben 22, die zum Beispiel mit Polyimid oder Silikon gefüllt werden.

Auf der zweiten Hauptfläche 17 des zweiten Substrates 12 wird durch ganzflächige Abscheidung zum Beispiel in einem CVD-Verfahren und anschließende Strukturierung eine Nickelschicht zum Beispiel mittels Photolithographie zweite Metallflächen 23 und ein zweiter Kontakt 24 erzeugt. Der zweite Kontakt 24 füllt das zweite Kontaktloch 18 vollständig auf. Der zweite Kontakt 24 und die zweiten Metallflächen 23 bilden eine zur zweiten Hauptfläche parallele ebene Oberfläche.

Auf die ersten Metallflächen 20 und den ersten Kontakt 21 wird ein Lotmetall 25 aufgebracht. Das Lotmetall 25 besteht zum Beispiel aus Gallium. Es benetzt die Oberfläche der isolierenden Gräben 22 nicht.

Bei der Strukturierung der Nickelschicht werden auch zwischen den zweiten Metallflächen 23 und dem zweiten Kontakt 24 zweite isolierende Graben 26 gebildet, die mit Silikon oder Polyimid gefüllt werden.

Das erste Substrat 11 und das zweite Substrat 12 werden so zusammengefügt, daß die erste Hauptfläche 15 und die zweite Hauptfläche 17 aneinander grenzen und der erste Kontakt 21 auf den zweiten Kontakt 24 und die ersten Metallflächen 20 auf die zweiten Metallflächen 23 treffen. Bei der Strukturierung der Kontakte und Metallflächen wird eine im wesentlichen spiegelbildliche Anordnung erzeugt. Daher treffen die ersten isolierenden Graben 22 auf die zweiten isolierenden Graben 26. Das Lotmetall 25 wird erhitzt und geschmolzen. Das zweite Substrat 12 und das erste Substrat 11 werden unter Druck zusammengepreßt, wobei sich das flüssige Lotmetall 25 mit den zweiten Metallflächen 23 und dem zweiten Kontakt 24 durchmischt und zu einer intermetallischen Phase verfestigt. Das flüssige Lotmetall wird dabei aufgebraucht.

Bei Abmessungen der ersten isolierenden Graben 22 und der zweiten isolierenden Graben 26 von mindestens einem µm und einer Schichtdicke des Lotmetalls 25 von maximal einem µm kann in dieser Anordnung das erste Substrat 11 mit dem zweiten Substrat 12 mit einem Druck von 10 kg pro cm² zusammengepreßt werden, ohne daß Kurzschlüsse über das flüssige Lotmetall entstehen. Während des Lötvorgangs bilden sich an den Rändern der Metallflächen und Kontakte Menisken aus, die verhindern, daß flüssiges Lotmetall in den Bereich der isolierenden Gräben eintritt.

Das Lotmetall 25 wird vorzugsweise in einer Schichtdicke aufgebracht, so daß der Galliumanteil im Nickel nach dem Verlöten unter 25 Gewichtsprozent bleibt. Dann weist die beim Löten entstandene intermetallische Phase eine Schmelztemperatur von über 1200°C auf. Bei üblichen Dicken der Kontaktlöcher und Metallflächen im Bereich von 1 bis 2 µm ist dieses bei einer Schichtdicke des Lotmetalls 25 von maximal 0,5 µm der Fall.

Beim Erhitzen des Lotmetalls 25 muß darauf geachtet werden, daß die Ausbildung der intermetallischen Phase erst beginnt, wenn beide Substrate über das flüssige Lotmetall in Kontakt stehen. Dieses läßt sich erreichen durch Erhitzen erst nach dem Zusammenfügen der beiden Substrate oder durch Verwendung eines entsprechenden Metalls, zum Beispiel Wolfram für die ersten Metallflächen 20 und den ersten Kontakt 21 und/oder das Vorsehen von Diffusionsbarriereschichten, zum Beispiel Titan oder Titannitrid, auf der Oberfläche der ersten Metallflächen 20 und des ersten Kontaktes 21.

Nach dem Zusammenlöten sind das erste Substrat 11 und das zweite Substrat 12 über die ersten Metallflächen 20 und die zweiten Metallflächen 23 mechanisch miteinander verbunden. Die elektrische Verbindung erfolgt über den ersten Kontakt 21 und den zweiten Kontakt 24. Die verlöteten Metallflächen 20, 23 dienen neben der mechanischen Verbindung auch zur Ableitung der Wärme von oberen Ebenen zu Kühlflächen, die in der Regel unterhalb des Stapels montiert werden. Die verlöteten Metallflächen 20, 23 können elektrisch mit Masse oder Betriebsspannung verbunden werden, so daß sie eine elektrische Abschirmung der Schaltungsstrukturen in den beiden Substraten bewirken. Ferner lassen sich über die Metallflächen 20, 23 Wellenleiterstrukturen für horizontale Leitungen realisieren.

Nach dem Zusammenfügen des ersten Substrats 11 und des zweiten Substrats 12 und dem Verlöten ist es zweckmäßig, die Schaltungsstrukturen in den Substraten zu testen. Stellt sich heraus, daß die Schaltungsstrukturen im zweiten Substrat 12 fehlerhaft sind, so kann das zweite Substrat 12 durch Abschleifen wieder entfernt werden. Bei dem Abschleifen werden auch die zweiten Metallflächen 23 und das Lotmetall 25 entfernt. Das Abschleifen wird fortgesetzt bis mindestens die Oberfläche der ersten Metallflächen 20 und des ersten Kontaktes 21 freigelegt sind. Nach einem Reinigungsschritt kann anschließend nach dem erfindungsgemäßen Verfahren erneut ein zweites Substrat aufgebracht und verlötet werden.

In einer ersten Hauptfläche 35 eines ersten Substrates 31 (siehe Figur 2), das analog dem ersten Substrat 11 aus Figur 1 aufgebaut ist und das eine Metallisierungsebene 33 umfaßt, die gegenüber dem ersten Substrat 31 durch eine SiO₂-Schicht 311 isoliert ist, wird ein erstes Kontaktloch 36 geöffnet, das auf die Metallisierungsebene 33 reicht. Das erste Kontaktloch 36 wird mit einem ersten Kontakt 41 aus zum Beispiel Wolfram aufgefüllt. Auf der ersten Hauptfläche 35 werden durch ganzflächiges Abscheiden einer Schicht aus zum Beispiel Wolfram und anschließendes Strukturieren mit Photolithographie erste Metallflächen 40, 40a erzeugt. Eine der ersten Metallflächen 40a überdeckt den ersten Kontakt 41 und überragt ihn seitlich.

Zwischen benachbarten ersten Metallflächen 40 sind erste isolierende Gräben 42 angeordnet, die zum Beispiel mit Silikon oder Polyimid gefüllt werden.

Ein zweites Substrat 32, das analog dem zweiten Substrat 12 aus Figur 1 aufgebaut ist, umfaßt mindestens eine Metallisierungsebene 34, die gegenüber dem Substrat 32 durch eine SiO₂-Schicht 321 isoliert ist. In einer zweiten Hauptfläche 37 des zweiten Substrates 32 wird ein zweites Kontaktloch 38 geöffnet. Das zweite Kontaktloch 38 reicht bis auf die Metallisierungsebene 34. Die Oberfläche des zweiten Substrates 32 wird mit einer isolierenden Schicht 39 versehen, die zum Beispiel aus SiO₂ besteht und die die Oberfläche der Metallisierungsebene 34 freiläßt.

Durch ganzflächiges Abscheiden einer Nickelschicht und Strukturieren zum Beispiel mit Hilfe von Photolithographie werden ein zweiter Kontakt 44 und zweite Metallflächen 43, 43a gebildet. Eine der zweiten Metallflächen 43a überdeckt den Kontakt 41 und überragt ihn seitlich. Der zweite Kontakt 44 füllt das zweite Kontaktloch 38 im wesentlichen aus und bildet mit den zweiten Kontaktflächen 43 eine zur zweiten Hauptfläche 37 parallele, ebene Oberfläche. Zwischen den zweiten Metallflächen 43 und dem zweiten Kontakt 44 sind an der zweiten Hauptfläche 37 isolierende Gräben 46, die mit Polyimid oder Silikon gefüllt werden, entstanden.

Auf die ersten Metallflächen 40 des ersten Substrates 31 wird Lotmetall 45 aufgebracht. Das Lotmetall 45 besteht zum Beispiel aus Gallium und wird in einer Dicke von zum Beispiel 250 nm aufgebracht.

Das zweite Substrat 32 wird so mit dem ersten Substrat 31 zusammengefügt, daß die erste Hauptfläche 35 an die zweite Hauptfläche 37 angrenzt und daß die zweite Metallfläche 43a auf die erste Metallfläche 40a trifft.

Durch Erhitzen und Zusammendrücken der beiden Substrate wird, analog wie anhand von Figur 1 geschildert, eine feste Verbindung zwischen dem ersten Substrat 31 und dem zweiten Substrat 32 gebildet. In dieser Ausführungsform wird eine elektrische Verbindung zwischen dem ersten Kontakt 41 und dem zweiten Kontakt 44 über die die Kontakte 41 und 44 seitlich überragenden Metallflächen 40a und 43a gebildet. Diese Metallflächen 40a und 43a stellen eine die beiden Kontakte verbindende Leiterbahn dar.

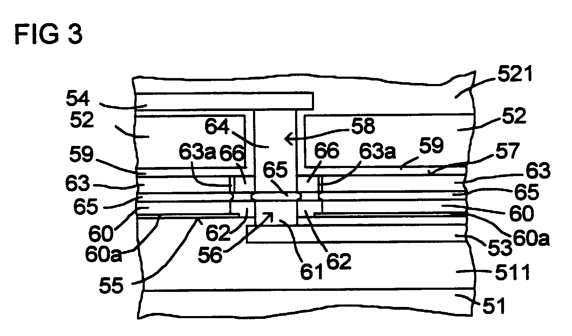

Ein erstes Substrat 51 (siehe Figur 3), das zum Beispiel eine Haibleiterscheibe aus einkristallinem Silizium oder ein III-V-Halbleiter ist, umfaßt Schaltungsstrukturen, die Bestandteil einer mikroelektronischen Schaltung oder einer optoelektronischen Komponente oder einer Sensorkomponente sind. Die Schaltungsstrukturen, die im einzelnen in Figur 3 nicht dargestellt sind, umfassen mindestens eine Metallisierungsebene 53, die durch eine SiO₂-Schicht 511 gegenüber dem Substrat 51 isoliert ist. Ein zweites Substrat 52 ist zum Beispiel ein vereinzelter Chip, der eine mikroelektronische Schaltung, eine optoelektronische Komponente oder eine Sensorkomponente umfaßt. Die Schaltungsstrukturen des zweiten Substrats 52 sind in Figur 3 nicht im einzelnen dargestellt. Sie umfassen mindestens eine Metallisierungsebene 54, die durch eine SiO₂-Schicht 521 gegenüber dem Substrat 52 isoliert ist. In einer ersten Hauptfläche 55 des ersten Substrates 51 wird ein erstes Kontaktloch 56 geöffnet. Das erste Kontaktloch 56 reicht bis auf die Metallisierungsebene 53.

In einer zweiten Hauptfläche 57 des zweiten Substrats 52 wird ein zweites Kontaktloch 58 geöffnet. Das zweite Kontaktloch 58 reicht auf die Metallisierungsebene 54. Die Oberfläche des zweiten Substrats 52 wird mit einer isolierenden Schicht 59 aus zum Beispiel SiO₂ versehen. Dabei bleibt im Bereich des zweiten Kontaktloches 58 die Oberfläche der Metallisierungsebene 54 unbedeckt.

Durch ganzflächige Abscheidung zum Beispiel durch Sputtern und anschließende Strukturierung mit Hilfe eines photolithographischen Verfahrens von einem durch das Lotmetall nicht benetzbaren Material wird auf der ersten Hauptfläche 55 eine Hilfsschicht 60a erzeugt.

Durch ganzflächige Abscheidung zum Beispiel in einem CVD-Verfahren und anschließende Strukturierung mit Hilfe eines photolithographischen Verfahrens einer Wolframschicht werden auf der ersten Hilfsschicht 60a erste Metallflachen 60 und ein erster Kontakt 61 gebildet. Der erste Kontakt 61 füllt das erste Kontaktloch 56 aus.

Die erste Hilfsschicht 60a ist unter den ersten Metallflächen 60 angeordnet. Zwischen den ersten Metallflächen 60 und dem ersten Kontakt 61 entstehen isolierende Gräben 62. Die erste Hilfsschicht 60a ragt unter den ersten Metallflächen 60 seitlich bis in die isolierenden Graben 62 hinein. Zwischen der ersten Hilfsschicht 60a und dem ersten Kontakt 61 besteht ein Abstand. Vorzugsweise wird die erste Hilfsschicht 60a aus Wolfram, Tantal, Aluminium oder Polymer gebildet.

Auf der zweiten Hauptflache 57 des zweiten Substrates 52 wird durch ganzflächige Abscheidung zum Beispiel in einem CVD-Verfahren und anschließende Strukturierung eine Nickelschicht zum Beispiel mittels Photolithographie zweite Metallflächen 63 und ein zweiter Kontakt 64 erzeugt. Der zweite Kontakt 64 füllt das zweite Kontaktloch 58 vollständig auf. Der zweite Kontakt 64 und die zweiten Metallflächen 63 bilden eine zur zweiten Hauptfläche parallele ebene Oberfläche.

Bei der Strukturierung der Nickelschicht werden auch zwischen den zweiten Metallflächen 63 und dem zweiten Kontakt 64 zweite isolierende Gräben 66 gebildet.

Durch ganzflächiges Abscheiden von durch das Lotmetall nicht benetzbarem Material und anisotropes Rückätzen wird an den Flanken der zweiten Metallflächen 63 eine zweite Hilfsschicht 63a erzeugt. Die zweite Hilfsschicht 63a ist als Flankenbedeckung ausgebildet und bedeckt nur die Flanken der zweiten Metallflächen 63. Die zweite Hilfsschicht 63a wird vorzugsweise aus Wolfram, Tantal, Aluminium oder Polymer gebildet.

Alternativ kann das Lotmetall auch oxidiert werden (z. B. in einem Sauerstoffplasma). Nach anschließendem anisotropen Rückätzen des Oxids bleibt der Oxidfilm als Flankenbedeckung der Metallflächen 63 zurück.

Eine weitere Möglichkeit besteht darin, die Scheibe ganzflächig mit einem Polymer, z. B. Polyimid oder Photolack, zu bedecken und mit Sauerstoffplasma oder naßchemisch so weit zurück zu ätzen, daß die Isolationsgräben noch ganz oder teilweise gefüllt bleiben.

So lassen sich die Gräben auch mit einem Isolator füllen, wenn zum Beispiel aus Korrosionsgründen die Gräben nicht geöffnet bleiben dürfen.

Auf die ersten Metallflächen 60 und den ersten Kontakt 61 wird ein Lotmetall 65 aufgebracht. Das Lotmetall 65 besteht zum Beispiel aus Gallium. Es benetzt die Oberfläche der ersten Hilfsschicht 60a und der zweiten Hilfsschicht 63a nicht.

Das erste Substrat 51 und das zweite Substrat 52 werden so zusammengefügt, daß die erste Hauptfläche 55 und die zweite Hauptfläche 57 aneinander grenzen und der erste Kontakt 61 auf den zweiten Kontakt 64 und die ersten Metallflächen 60 auf die zweiten Metallflächen 63 treffen. Zwischen dem ersten Substrat 51 und dem zweiten Substrat 52 eingeschlossene Luft- oder Schutzgasatmosphäre kann dabei über die ersten isolierenden Gräben 62 und die zweiten isolierenden Gräben 66 entweichen.

Bei der Strukturierung der Kontakte und Metallflächen wird eine im wesentlichen spiegelbildliche Anordnung erzeugt. Daher treffen die ersten isolierenden Graben 62 auf die zweiten isolierenden Graben 66. Das Lotmetall 65 wird erhitzt und geschmolzen. Das zweite Substrat 52 und das erste Substrat 51 werden unter Druck zusammengepreßt, wobei sich das flüssige Lotmetall 65 mit den zweiten Metallflächen 63 und dem zweiten Kontakt 64 durchmischt und zu einer intermetallischen Phase verfestigt. Das Lotmetall 65 wird dabei vollständig verbraucht.

Bei Abmessungen der ersten isolierenden Graben 62 und der zweiten isolierenden Graben 66 von mindestens einem µm und einer Schichtdicke der ersten Hilfsschicht 60a und der zweiten Hilfsschicht 63a von jeweils 100 nm und einer Schichtdicke des Lotmetalls 65 von maximal einem µm kann in dieser Anordnung das erste Substrat 51 mit dem zweiten Substrat 52 mit einem Druck von 10 kg pro cm² zusammengepreßt werden, ohne daß Kurzschlüsse über das flüssige Lotmetall entstehen. Während des Lötvorgangs bilden sich an den Rändern der Metallflächen und Kontakte Menisken aus, die verhindern, daß flüssiges Lotmetall in den Bereich der isolierenden Graben eintritt.

Das Lotmetall 65 wird vorzugsweise in einer Schichtdicke aufgebracht, so daß der Galliumanteil im Nickel nach dem Verlöten unter 25 Gewichtsprozent bleibt. Dann weist die beim Löten entstandene Legierung eine Schmelztemperatur von über 1200°C auf. Bei üblichen Dicken der Kontaktlöcher und Metallflächen im Bereich von 1 bis 2 µm ist dieses bei einer Schichtdicke des Lotmetalls 65 von maximal 0,5 µm der Fall.

Beim Erhitzen des Lotmetalls 65 muß darauf geachtet werden, daß das Ausbilden der intermetallischen Pfase erst beginnt, wenn beide Substrate über das flüssige Lotmetall in Kontakt stehen. Dieses laßt sich erreichen durch Erhitzen erst nach dem Zusammenfügen der beiden Substrate oder durch Verwendung eines entsprechenden Metalls, zum Beispiel Titan für die ersten Metallflachen 60 und den ersten Kontakt 61 und/oder das Vorsehen von Diffusionsbarriereschichten, zum Beispiel Titannitrid, auf der Oberfläche der ersten Metallflächen 60 und des ersten Kontaktes 61.

Nach dem Zusammenlöten sind das erste Substrat 51 und das zweite Substrat 52 über die ersten Metallflächen 60 und die zweiten Metallflächen 63 mechanisch miteinander verbunden. Die elektrische Verbindung erfolgt über den ersten Kontakt 61 und den zweiten Kontakt 64. Die verlöteten Metallflächen 60, 63 dienen neben der mechanischen Verbindung auch zur Ableitung der Warme von oberen Ebenen zu Kühlflächen, die in der Regel unterhalb des Stapels montiert werden. Die verlöteten Metallflächen 60, 63 können elektrisch mit Masse oder Betriebsspannung verbunden werden, so daß sie eine elektrische Abschirmung der Schaltungsstrukturen in den beiden Substraten bewirken. Ferner lassen sich über die Metallflächen 60, 63 Wellenleiterstrukturen für horizontale Leitungen realisieren.

Nach dem Zusammenfügen des ersten Substrats 51 und des zweiten Substrats 52 und dem Verlöten ist es zweckmäßig, die Schaltungsstrukturen in den Substraten zu testen. Stellt sich heraus, daß die Schaltungsstrukturen im zweiten Substrat 52 fehlerhaft sind, so kann das zweite Substrat 52 durch Abschleifen wieder entfernt werden. Bei dem Abschleifen werden auch die zweiten Metallflächen 63 und das Lotmetall 65 entfernt. Das Abschleifen wird fortgesetzt bis mindestens die Oberfläche der ersten Metallflächen 60 und des ersten Kontaktes 61 freigelegt sind. Nach einem Reinigungsschritt kann anschließend nach dem erfindungsgemäßen Verfahren erneut ein zweites Substrat aufgebracht und verlötet werden.

Das erfindungsgemäße Verfahren wurde anhand der Verbindung zweier Substrate geschildert. Mit Hilfe des erfindungsgemäßen Verfahrens lassen sich beliebig viele Substrate übereinander stapeln und fest miteinander verbinden. Durch Verwendung eines ersten Substrates, das bereits ein erfindungsgemäß hergestellter Stapel von n - 1 Substraten ist, mit einem weiteren Substrat läßt sich ein Stapel aus n Substraten erfindungsgemäß zusammenfügen.

## Patentansprüche

1. Verfahren zur Herstellung einer dreidimensionalen Schaltungsanordnung,
- bei dem ein erstes Substrat (11) und ein zweites Substrat (12), die jeweils mindestens ein Bauelement mit Kontakten umfassen, als Stapel übereinander angeordnet werden,
- bei dem auf die an das andere Substrat angrenzende Hauptfläche (15) mindestens eines der Substrate (11) Metallflächen (20) aufgebracht werden,
- bei dem die Metallflächen (23) durch Aufbringen von Lotmetall (25) und Erhitzen mit der angrenzenden Hauptfläche (17) des anderen Substrats (12) verlötet werden, wobei sich das Lotmetall (25) mit Material der Metallflächen (23) vollständig durchmischt, so daß sich eine intermetalische Phase bildet und so daß nach dem Verlöten zwischen den Substraten kein reines Lotmetall verbleibt und wodurch eine feste Verbindung zwischen dem ersten Substrat (11) und dem zweiten Substrat (12) entsteht,
- bei dem das Material der Metallflächen (23) und das Lotmetall (25) so aufeinander abgestimmt werden, daß die Schmelztemperatur der intermetallischen Phase höher als die Betriebstemperatur der dreidimensionalen Schaltungsanordnung und höher als die Schmelztemperatur des reinen Lotmetalls ist,
- bei dem zwischen den Metallflächen (20, 23; und auf derselben Hauptfläche angeordneten, benachbarten Kontakten (11, 24) isolierende Gräben (22, 26) gebildet werden.

2. Verfahren nach Anspruch 1,
- bei dem die Metallflächen (23) Nickel enthalten und das Lotmetall (25) Gallium enthält,
- bei dem die Menge des Lotmetalis (25) so bemessen wird, daß sich nach der vollständigen Durchmischung mit dem Material der Metallflächen (23) eine intermetallische Phase mit einem Galliumanteil von maximal 25 Gewichtsprozent bildet.

3. Verfahren nach Anspruch 1 oder 2,
- bei dem zusätzliche Metallflächen (20), die jeweils an eine der erstgenannten Metallflächen (23) angrenzen, auf der Hauptfläche (17) des jeweils anderen Substrates (12) aufgebracht werden,
- bei dem die erstgenannten Metallflächen (23) mit den angrenzenden zusätzlichen Metallflächen (20) verlötet werden.

4. Verfahren nach Anspruch 3,
bei dem die zusätzlichen Metallflächen (20) aus Wolfram gebildet werden.

5. Verfahren nach einem der Ansprüche 1 bis 4,
- bei dem in beiden Substraten (11, 12) Kontakte (21, 24) an die an das andere Substrat angrenzende Hauptfläche angrenzen,
- bei dem das Lotmetall (25) beim Verlöten eine elektrische Verbindung zwischen zu kontaktierenden Kontakten (21, 24) des ersten Substrats (11) und des zweiten Substrats (12) bilden.

6. Verfahren nach einem der Ansprüche 1 bis 5,
bei dem die isolierenden Graben (22, 26) mit Material gefüllt werden, das vom Lotmetall (25) nicht benetzt wird.

7. Verfahren nach Anspruch 6,
- bei dem die isolierenden Graben (22, 26) eine Weite von mindestens einem µm aufweisen,
- bei dem das Lotmetall (25) als Schicht in einer Dicke von höchstens einem µm aufgebracht wird,
- bei dem die isolierenden Gräben (22, 26) mit Polyimid oder Silikon gefüllt werden.

8. Verfahren nach einem der Ansprüche 1 bis 5,
- bei dem der Boden des isolierenden Grabens (62) mindestens teilweise mit einer Hilfsschicht (60a) bedeckt wird, die von dem Lotmetall (65) nicht benetzbar ist,
- bei dem die Hilfsschicht (60a) mindestens den Rand des Bodens des isolierenden Grabens (62) bedeckt.

9. Verfahren nach Anspruch 8,
bei dem die Hilfsschicht (63a) Flanken der Metallflächen (63) bedeckt, die an die isolierenden Graben (66) angrenzen.

10. Verfahren nach Anspruch 8,
bei dein die Hilfsschicht (60a) unter der Metallfläche (60) angeordnet wird.

11. Verfahren nach einem der Ansprüche 8 bis 10,
bei dem die Hilfsschicht (20a, 23a) aus Wolfram, Tantal, Aluminium, Titanoxid, Tantaloxid, Chromoxid, einem Nitrid oder einem Polymer gebildet wird.

12. Verfahren nach Anspruch 5,
bei dem zur elektrischen Verbindung von einem ersten Kontakt (41) im ersten Substrat (31) und einem zweiten Kontakt (44) im zweiten Substrat (32), die im Bereich der aneinander grenzenden Hauptflächen nicht aufeinander treffen, mindestens eine Metallfläche (40a) so gebildet wird, daß sie eine Leiterbahn zwischen dem ersten Kontakt (41) und dem zweiten Kontakt (44) bildet.

13. Verfahren nach einem der Ansprüche 1 bis 12,
bei dem auf die erstgenannten Metallflächen (20) vor dem Aufbringen des Lotmetalls (25) eine Diffusionsbarriereschicht aufgebracht wird, die die Diffusion des Lotmetalls (25) in die erstgenannten Metallflächen verzögert.

14. Verfahren nach einem der Ansprüche 1 bis 13,
- bei dem nach der Verbindung des ersten Substrats (11) und des zweiten Substrats (12) durch Verlöten die darin enthaltenen Bauelemente getestet werden,
- bei dem beim Auftreten fehlerhafter Bauelemente das diese enthaltende Substrat durch Abschleifen entfernt wird,
- bei dem beim Abschleifen das Lotmetall (25) entfernt und bis in die auf dem verbleibenden Substrat angeordneten Metallflächen hineingeschliffen wird, so daß über diese ein neues Substrat mit dem verbleibenden Substrat verlötet werden kann.

## Claims

1. Method for producing a three-dimensional circuit arrangement,
- in which a first substrate (11) and a second substrate (12), which each comprise at least one component with contacts, are arranged one above the other as a stack,
- in which metal surfaces (20) are applied onto that main surface (15) of at least one of the substrates (11) which is adjacent to the other substrate,
- in which the metal surfaces (23) are soldered to the adjacent main surface (17) of the other substrate (12) by application of solder metal (25) and heating, the solder metal (25) mixing completely with the material of the metal surfaces (23) so that an intermetallic phase is formed and so that no pure solder metal remains between the substrates after soldering, and as a result, a firm joint is produced between the first substrate (11) and the second substrate (12),
- in which the material of the metal surfaces (23) and the solder metal (25) are matched to one another such that the melting temperature of the intermetallic phase is higher than the operating temperature of the three-dimensional circuit arrangement and is higher than the melting temperature of the pure solder metal,
- in which insulating trenches (22, 26) are formed between the metal surfaces (20, 23) and adjacent contacts (11, 24) which are arranged on the same main surface.

2. Method according to Claim 1,
- in which the metal surfaces (23) include nickel and the solder metal (25) includes gallium,
- in which the quantity of solder metal (25) is dimensioned such that an intermetallic phase having a gallium component of a maximum of 25 per cent by weight forms after the complete mixing with the material of the metal surfaces (23).

3. Method according to Claim 1 or 2,
- in which additional metal surfaces (20), which are in each case adjacent to one of the first-mentioned metal surfaces (23), are applied on the main surface (17) of the respective other substrate (12),
- in which the first-mentioned metal surfaces (23) are soldered to the adjacent additional metal surfaces (20).

4. Method according to Claim 3,
in which the additional metal surfaces (20) are formed from tungsten.

5. Method according to one of Claims 1 to 4,
- in which contacts (21, 24) in both substrates (11, 12) are adjacent to the main surface which is adjacent to the other substrate,
- in which, during soldering, the solder metal (25) forms an electrical connection between contacts (21, 24), with which contact is to be made, on the first substrate (11) and on the second substrate (12).

6. Method according to one of Claims 1 to 5,
in which the insulating trenches (22, 26) are filled with material which is not wetted by the solder metal (25).

7. Method according to Claim 6,
- in which the insulating trenches (22, 26) have a width of at least one mm,
- in which the solder metal (25) is applied as a layer with a thickness of at most one mm,
- in which the insulating trenches (22, 26) are filled with polyimide or silicone.

8. Method according to one of Claims 1 to 5,
- in which the base of the insulating trench (62) is at least partially covered by an auxiliary layer (60a) which cannot be wetted by the solder metal (65),
- in which the auxiliary layer (60a) covers at least the edge of the base of the insulating trench (62).

9. Method according to Claim 8,
in which the auxiliary layer (63a) covers flanks of the metal surfaces (63) which are adjacent to the insulating trenches (66).

10. Method according to Claim 8,
in which the auxiliary layer (60a) is arranged under the metal surface (60).

11. Method according to one of Claims 8 to 10,
in which the auxiliary layer (20a, 23a) is formed from tungsten, tantalum, aluminium, titanium oxide, tantalum oxide, chromium oxide, a nitride or a polymer.

12. Method according to Claim 5,
in which at least one metal surface (40a) is formed for the electrical connection of a first contact (41) in the first substrate (31) and a second contact (44) in the second substrate (32), which do not meet one another in the region of the mutually adjacent main surfaces, such that said metal surface (40a) forms an interconnect between the first contact (41) and the second contact (44).

13. Method according to one of Claims 1 to 12,
in which a diffusion barrier layer is applied onto the first-mentioned metal surfaces (20) before the application of the solder metal (25), which diffusion barrier layer delays the diffusion of the solder metal (25) into the first-mentioned metal surfaces.

14. Method according to one of Claims 1 to 13,
- in which, after the first substrate (11) and the second substrate (12) have been joined by soldering, the components included therein are tested,
- in which, if faulty components occur, the substrate including them is removed by grinding away,
- in which the solder metal (25) is removed during the grinding away operation and is ground as far as the metal surfaces which are arranged on the remaining substrate, such that a new substrate can be soldered via these metal surfaces to the remaining substrate.

## Revendications

1. Procédé de fabrication d'un circuit intégré tridimensionnel, dans lequel
- on met l'un sur l'autre sous forme d'empilement un premier substrat (11) et un deuxième substrat (12) qui comprennent chacun au moins un composant ayant des contacts,
- on applique des surfaces métalliques (23) sur la surface principale (15), adjacente à l'autre substrat, d'au moins l'un des substrats (11),
- en appliquant du métal à braser (25) et en le chauffant, on brase les surfaces métalliques (23) avec la surface principale adjacente (17) de l'autre substrat (12), le métal à braser (25) se mélangeant complètement avec le matériau des surfaces métalliques (23) de telle sorte qu'il se forme une phase intermétallique et qu'il ne reste pas après le brasage de métal à braser pur entre les substrats, ce qui fait qu'il se forme une liaison solide entre le premier substrat (11) et le deuxième substrat (12),
- on adapte l'un à l'autre le matériau des surfaces métalliques (23) et le métal à braser (25) de telle sorte que la température de fusion de la phase intermétallique soit supérieure à la température de fonctionnement du circuit intégré tridimensionnel et supérieure à la température de fusion du métal à braser pur,
- on forme des tranchées isolantes (22, 26) entre les surfaces métalliques (20, 23) et des contacts (11, 24) voisins prévues sur la même surface principale.

2. Procédé selon la revendication 1, dans lequel
- les surfaces métalliques (23) contiennent du nickel et le métal à braser (25) contient du gallium,
- on mesure la quantité du métal à braser (25) de telle sorte que, après le mélange complet avec le matériau des surfaces métalliques (23), il se forme une phase intermétallique ayant une proportion de gallium de 25 % en poids au maximum.

3. Procédé selon la revendication 1 ou 2, dans lequel
- on applique des surfaces métalliques supplémentaires (20), qui sont à chaque fois adjacentes à l'une des surfaces métalliques (23) mentionnées en premier, sur la surface principale (17) de l'autre substrat respectif (12),
- on brase les surfaces métalliques (23) mentionnées en premier avec les surfaces métalliques supplémentaires (20) adjacentes.

4. Procédé selon la revendication 3,
dans lequel les surfaces métalliques supplémentaires (20) sont en tungstène.

5. Procédé selon l'une des revendications 1 à 4, dans lequel
- dans les deux substrats (11, 12), des contacts (21, 24) sont adjacents à la surface principale adjacente à l'autre substrat,
- le métal à braser (25) forme lors du brasage une liaison électrique entre des contacts (21, 24), à mettre en contact, du premier substrat (11) et du deuxième substrat (12).

6. Procédé selon l'une des revendications 1 à 5, dans lequel,
on remplit les tranchées isolantes (22, 26) d'un matériau qui n'est pas mouillé par le métal à braser (25).

7. Procédé selon la revendication 6, dans lequel
- les tranchées isolantes (22, 26) ont une largeur d'au moins un µm,
- on applique le métal à braser (25) sous la forme d'une couche d'une épaisseur d'au plus un µm,
- on remplit les tranchées isolantes (22, 26) de polyimide ou de silicone.

8. Procédé selon l'une des revendications 1 à 5, dans lequel
- on recouvre le fond de la tranchée isolante (62) au moins partiellement d'une couche auxiliaire (60a) qui ne peut pas être mouillée par le métal à braser (65),
- la couche auxiliaire (60a) recouvre au moins le bord du fond de la tranchée isolante (62).

9. Procédé selon la revendication 8, dans lequel
la couche auxiliaire (63a) recouvre des flancs des surfaces métalliques (63) qui sont adjacents aux tranchées isolantes (66).

10. Procédé selon la revendication 8, dans lequel
on met la couche auxiliaire (60a) sous la surface métallique (60).

11. Procédé selon l'une des revendications 8 à 10, dans lequel
la couche auxiliaire (20a, 23a) est en tungstène, en tantale, en aluminium, en oxyde de tantale, en oxyde de chrome, en un nitrure ou en un polymère.

12. Procédé selon la revendication 5, dans lequel
pour la liaison électrique d'un premier contact (41) dans le premier substrat (31) et d'un deuxième contact (44) dans le deuxième substrat (32), qui ne coïncident pas l'un sur l'autre dans la zone des surfaces principales adjacentes l'une à l'autre, on forme au moins une surface métallique (40a) de telle sorte qu'elle forme une piste conductrice entre le premier contact (41) et le deuxième contact (44).

13. Procédé selon l'une des revendications 1 à 12, dans lequel
avant l'application du métal à braser (25), on applique sur les surfaces métalliques (20) mentionnées en premier une couche de barrière de diffusion qui retarde la diffusion du métal à braser (25) dans les surfaces métalliques mentionnées en premier.

14. Procédé selon l'une des revendications 1 à 13, dans lequel
- après la liaison du premier substrat (11) et du deuxième substrat (12) par brasage, on teste les composants qu'ils contiennent,
- en présence de composants défectueux, on enlève par rodage le substrat contenant ces composants défectueux,
- lors du rodage, on enlève le métal à braser (25) et on rode jusque dans les surfaces métalliques prévues sur le substrat restant de telle sorte que, au-dessus de celles-ci, on peut braser un nouveau substrat avec le substrat restant.
